# FASCICULE DE BREVET EUROPEEN

(11) **EP 0 886 315 B1**
(45) Date de publication et mention de la délivrance du brevet: **13.10.2004**
(21) Numéro de dépôt: 98401413.4
(22) Date de dépôt: 11.06.1998
(51) Int. Cl.: H01L 25/07

(54) **Module d'électronique de puissance et un dispositif d'électronique de puissance pourvu de tels modules**
Elektronisches Leistungsmodul und Leistungsgerät damit
Electronic power module and electronic power device employing the same

(30) Priorité: 19.06.1997 FR 9707637
(43) Date de publication de la demande: 23.12.1998
(73) Titulaire: ALCATEL, 75008 Paris (FR)
(72) Inventeur: Ranchy, Eric, 92140 Clamart (FR); Petitbon, Alain, 78730 St. Arnoult en Yvelines (FR)
(74) Mandataire: Sciaux, Edmond

(56) Documents cités:
- DE-U- 29 504 352
- US-A- 4 878 106
- PATENT ABSTRACTS OF JAPAN vol. 018, no. 531 (E-1614), 7 octobre 1994 & JP 06 188363 A (MITSUBISHI ELECTRIC CORP), 8 juillet 1994
- PATENT ABSTRACTS OF JAPAN vol. 018, no. 556 (E-1620), 24 octobre 1994 & JP 06 204398 A (NEC CORP), 22 juillet 1994

## Description

L'invention concerne un module d'électronique de puissance et un dispositif d'électronique de puissance pourvu de tels modules. En particulier, la présente invention concerne un module d'électronique de puissance comprenant des matériaux standards, fabriqué selon des méthodes standards.

Les développements dans le cadre de l'électronique de puissance comprennent notamment :
la réduction de la taille des dispositifs, par exemple en réduisant les éléments de refroidissement en améliorant l'évacuation de la chaleur générée par les composants électroniques de .puissance,
la réalisation de concepts modulaires de manière à pouvoir monter en puissance par adjonction de modules similaires, et
l'utilisation des matériaux et des techniques de fabrications standards pour réduire les coûts de productions.

Le document DE-U-29 504 352 décrit un module d'électronique de puissance comprenant deux modules élémentaires chacun comprenant un composant électronique de puissance ayant une face de contact montée sur un échangeur de chaleur métallique pour évacuer les dissipations de puissance par effet joule du composant éiectronique de puissance, des connexions de commande pour connecter le composant à un module de commande, des connexions de puissance pour transmettre la puissance entre composants et/ou à d'autres modules élémentaires, dans lequel les deux modules élémentaires sont face à face, le composant électronique de puissance d'un module élémentaire en regard du composant électronique de puissance de l'autre module élémentaire, et séparés l'un de l'autre par deux entretoises comprenant une amenée de courart.

US-A-5296739 concerne un dispositif d'électronique de puissance comprenant une plaque supportant un composant d'électronique de puissance. Cette plaque comprend une couche métallique en contact avec un élément de refroidissement. La plaque comprend en outre des pistes conductrices pour connecter élément électronique de puissance à l'aide de fils de connexion. La conduction thermique est assurée par un élément presseur forçant le contact mécanique entre la plaque métallisée et élément de refroidissement.

Un premier inconvénient de US-A-5296739 résulte du fait que l'élément presseur est volumineux et n'a d'autres fonctions que de presser.

Un autre inconvénient de US-A-5296739 résulte de la modularité limitée du dispositif

Un autre inconvénient du US-A-5296733 résulte du volume de l'élément de refroidissement ainsi que de son manqué de modularité.

L'un des buts de la présente invention est de proposer un module d'électronique de puissance basé sur le principe de contact par pression mais présentant un agencement plus ergonomique relativement à la modularité, la réduction de volume, tant du dispositif de pressage que des éléments de refroidissement.

A cet effet l'invention concerne un module d'électronique de puissance ccmprenant deux modules élémentaires chacun comprenant au moins un composant électronique de puissance ayant au moins une face de contact montée sur une face d'un substrat, des connexions de commande pour connecter le composant à un module de commande, des connexions de puissance pour transmettre la puissance entre composants et/ou à d'autres modules élémentaires, et au moins un échangeur de chaleur métallique pour évacuer les dissipaticns de puissance par effet joule du composant électronique de puissance, monté sur l'autre face du substrat.

Selon l'invention, les deux modules élémentaires sont face à face, les composants électroniques de puissances de chaque module élémentaire étant en regard, les deux modules élémentaires sont séparés l'un de l'autre par au moins une entretoise comprenant des pistes de commande pour commander les modules élémentaires et des pistes de puissance pour transmettre la puissance vers les modules élémentaires ou entre modules élémentaires.

Le module d'électronique de puissance comprend des moyens de serrage pour assurer une solidarisation des modules élémentaires avec l'entretoise par serrage.

Dans une forme de réalisation, le substrat est du DBC.

L'échangeur de chaleur métallique comprend un circuit de circulation de fluide caloriporteur.

La face métallique du substrat au contact de l'échangeur de chaleur conscitue une des parois du circuit de circulation dudit échangeur de chaleur.

L'invention concerne aussi un dispositif d'électronique de puissance comprenant une pluralité de modules tels que décrits ci-dessus empilés les uns sur les autres et solidarisés ensemble par des moyens de serrage.

Avantageusement, deux modules adjacents partagent un échangeur de chaleur métallique commun.

Un premier avantage de la présente invention est de mettre les modules élémentaires face à face, séparés par une entretoise comprenant des pistes de puissance et de commande. Ainsi, l'élément presseur d'un module élémentaire est constitué par l'entretoise et l'autre des modules élémentaires. L'économie de place ainsi réalisée est conséquence.

Un autre avantage résulte du fait que dans un dispositif d'électronique de puissance selon l'invention, deux modules adjacents partagent un échangeur de chaleur métallique commun. Là encore la réduction de volume est conséquente. En outre, le dispositif de circulation du fluide de refroidissement est unique puisque les différents échangeurs de chaleur métalliques sont reliés entre eux par des canalisations.

Un autre avantage de la présente invention résulte de la véritable modularité du dispositif.

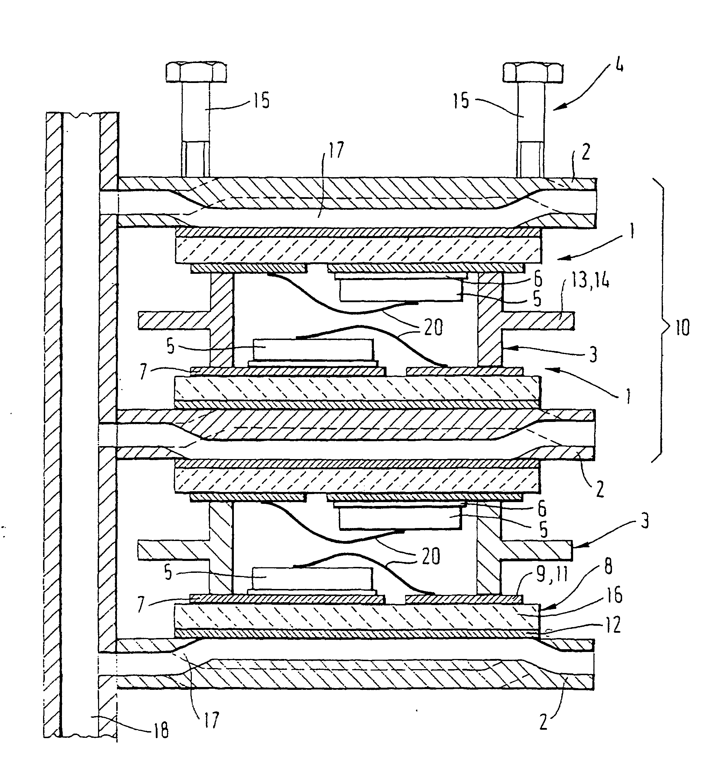

D'autres avantages et caractéristiques de la présente invention résulteront de la description qui va suivre en référence à la figure unique représentant schématiquement un dispositif électronique modulaire selon la présente invention.

Un module d'électronique de puissance selon l'invention comprend deux modules élémentaires 1 chacun comprenant au moins un composant électronique de puissance 5 ayant au moins une face de contact 5 montée sur une première face métallisée 7 d'un substrat isolant électrique 8. Le substrat 8 comprend en outre des pistes métallisées 9 pour des connexions de commande pour connecter le ou les composant(s) 5 à un module de commande (non représenté), et des pistes de puissance 11 pour transmettre la puissance entre composants 5 et/ou à d'autres modules élémentaires 1. Le substrat 8 comprend en outre une deuxième face métallisée 12 opposée à la première face 7, disposée au contact d'un échangeur de chaleur métallique 2 pour évacuer les dissipations de puissance par effet joule du ou des composant(s) électronique(s) de puissance 5.

Les deux modules élémentaires 1 constitutifs du module selon l'invention sont face à face, les composant électroniques de puissance 5 en regard.

Les deux modules élémentaires sont séparés l'un de l'autre par au moins une entretoise 3 comprenant des amenées de commande 14 pour relayer les commandes des modules élémentaires 1 et des amenées de puissance 13 pour transmettre la puissance vers les modules élémentaires 1 ou encre modules élémentaires 1.

Avantageusement et comme représenté sur la figure, les amenées de puissances 13 ou de commande 14 sont connectées respectivement aux pistes de puissance 11 et de commande 9, elles même connectées aux composants 5 constitutifs des modules élémentaires 1 par des connexions classiques 20.

Les composants électroniques de puissance 5 des modules élémentaires 1 sont soudés sur la première face métallisée 7 selon les techniques de soudage connues.

Des moyens de serrage 4 assurent une solidarisation des modules élémentaires 1 avec l'entretoise 3 par serrage. Par exemple, l'entretoise 3 est parfaitement maintenue entre les deux modules élémentaires 1 jouant le rôle de flasques, des tirants traversants 15 assurant le serrage.

Le substrat 8 peut être avantageusement du DBC. Le DBC comprend, de façon connue, deux faces métallisées en cuivre 9,11,7 ; 12 séparées par une couche de céramique 16 électriquement isolante.

Afin d'améliorer le transfert de chaleur, les échangeurs de chaleur métalliques 2, comprennent un circuit de circulation 17 de fluide caloriporteur.

Dans la forme de réalisation représentée sur la figure, la face métallique 12 au contact de l'échangeur de chaleur 2 constitue une des parois du circuit de circulation 17 dudit échangeur de chaleur 2. Cela permet de diminuer le nombre d'interfaces entre le composant 5 et le fluide caloriporteur et de ce fait d'augmenter le transfert de chaleur.

Dans la forme de réalisation représentée, les circuits de circulation 17 de fluide caloriporteur sont connectés à un même collecteur 18. Cela permet d'avoir un dispositif de mise en circulation et de recyclage du fluide de refroidissement (non représenté) unique pour l'ensemble du module ou du dispositif multi-modulaire.

L'invention concerne aussi un dispositif d'électronique de puissance comprenant une pluralité de modules 10 tels que décrits ci dessus, empilés les uns sur les autres et solidarisés ensemble par des moyens de serrage 4. Dans ce cas les deux modules élémentaires 1 d'extrémité des modules d'extrémité 10 jouent le rôle des flasques, et les tirants traversants 15 pressent ensemble les modules élémentaires 1 et les entretoises 3 intercalés.

Dans la forme de réalisation représentée sur la figure, deux modules élémentaires 1 adjacents de deux modules 10 différents ont un échangeur de chaleur métallique 2 commun.

Bien entendu, l'invention n'est pas limitée au mode de mise en oeuvre ou de réalisation décrit et représenté, mais elle est susceptible de nombreuses variantes accessibles à l'homme du métier sans que l'on s'écarte de l'invention.

## Revendications

1. Module d'électronique de puissance comprenant deux modules élémentaires (1) chacun comprenant au moins un composant électronique de puissance (5) ayant au moins une face de contact (6) montée sur une face métallique (7) d'un substrat (8), des connexions de commande (9, 14, 20) pour connecter le composant (1) à un module de commande, des connexions de puissance (11, 13, 20) pour transmettre la puissance entre composants (5) et/ou à d'autres modules élémentaires (1), et au moins un échangeur de chaleur métallique (2) pour évacuer les dissipations de puissance par effet joule du composant électronique de puissance (5), ledit échangeur de chaleur métallique (2) étant monté sur l'autre face (12) du substrat (8), dans lequel
les deux modules élémentaires (1) sont face à face, le composant électronique de puissance (5) d'un module élémentaire (1) en regard du composant électronique de puissance (5) de l'autre module élémentaire (1), et séparés l'un de l'autre par au moins une entretoise (3) comprenant des amenées de commande (14) pour commander les modules élémentaires (1) et des amenées de puissance (13) pour transmettre la puissance vers les modules élémentaires (1) ou entre modules élémentaires (1).

2. Module d'électronique de puissance selon la revendication 1 **caractérisé en ce qu'**il comprend des moyens de serrage (4) pour assurer une solidarisation des modules élémentaires (1) avec l'entretoise (3) par serrage.

3. Module d'électronique de puissance selon la revendication 1 ou 2 **caractérisé en ce que** le subscrat (8) est du DBC comprenant deux faces métallisées en cuivre (9,11,7 ; 12) séparées par une couche de céramique (16) électriquement isolante.

4. Module d'électronique de puissance selon l'une quelconque des revendications 1 à 3 **caractérisé en ce que** l'échangeur de chaleur métallique (2) comprend un circuit de circulation (17) de fluide caloriporteur.

5. Module d'électronique de puissance selon la revendication 4 **caractérisé** en ce la face métallique (12) du substrat (8) au contact de l'échangeur de chaleur (2) constitue une des parois du circuit de circulation (17) dudit échangeur de chaleur (2).

6. Dispositif d'électronique de puissance **caractérisé en ce qu'**il comprend une pluralité de modules (10) selon l'une quelconque des revendications 1 à 5 empilés les uns sur les autres et solidarisés ensemble par des moyens de serrage (4).

7. Dispositif d'électronique de puissance selon la revendication 6, **caractérisé en ce que** deux modules élémentaires adjacents de deux module (10) différents ont un échangeur de chaleur métallique (2) commun.

## Patentansprüche

1. Elektronisches Leistungsmodul, aufweisend zwei Elementarmodule (1), von denen jedes mindestens ein elektronisches Leistungsbauteil (5) mit mindestens einer auf eine Metallfläche (7) eines Substrats (8) montierten Kontaktfläche (6) aufweist, sowie Steuerverbindungen (9, 14, 20), um das Bauteil (1) mit einem Steuermodul zu verbinden, Leistungsverbindungen (11, 13, 20), um die Leistung zwischen Bauteilen (5) und/oder anderen Elementarmodulen (1) zu übertragen, und mindestens einen metallischen Wärmetauscher (2), um die Verlustleistungen des elektronischen Leistungsbauteils (5) durch Joulesche Wärme abzuführen, wobei der metallische Wärmetauscher (2) auf der anderen Seite (12) des Substrats (8) montiert ist; hierbei sind
die beiden Elementarmodule (1) zueinander zeigend angeordnet, wobei das elektronischen Leistungsmodul (5) eines Elementarmoduls (1) seitlich versetzt dem elektronischen Leistungsbauteil (5) des anderen Elementarmoduls (1) gegenübersteht und diese voneinander durch mindestens eine Strebe (3) getrennt sind, die Steuerzuleitungen (14) aufweist, um die Elementarmodule (1) zu steuern, sowie Leistungszuleitungen (13), um die Leistung zu den Elementarmodulen (1) oder zwischen Elementarmodulen (1) zu übertragen.

2. Elektronisches Leistungsmodul nach Anspruch 1, **dadurch gekennzeichnet, dass** es Klemmvorrichtungen (4) aufweist, um eine feste Verbindung der Elementarmodule (1) mit der Strebe (3) durch Zusammendrücken zu gewährleisten.

3. Elektronisches Leistungsmodul nach Anspruch 1 oder 2, **dadurch gekennzeichnet, dass** das Substrat (8) ein DBC-Substrat ist, das zwei kupferbeschichtete Flächen (9, 11, 7; 12) aufweist, die durch eine elektrisch isolierende Keramikschicht (16) voneinander getrennt sind.

4. Elektronisches Leistungsmodul nach einem beliebigen der Ansprüche 1 bis 3, **dadurch gekennzeichnet, dass** der metallische Wärmetauscher (2) einen Kreislauf (17) aufweist, in dem eine Kühlflüssigkeit umgewälzt wird.

5. Elektronisches Leistungsmodul nach Anspruch 4, **dadurch gekennzeichnet, dass** die Metallfläche (12) des Substrats (8), die mit dem Wärmetauscher (2) in Kontakt ist, eine der Wände des Umwälzkreislaufs (17) des Wärmetauschers (2) bildet.

6. Elektronisches Leistungsgerät, **dadurch gekennzeichnet, dass** es eine Vielzahl von Modulen (10) gemäß einem beliebigen der Ansprüche 1 bis 5 aufweist, die übereinander gestapelt und miteinander durch Klemmvorrichtungen (4) fest verbunden sind.

7. Elektronisches Leistungsgerät nach Anspruch 6, **dadurch gekennzeichnet, dass** zwei benachbarte Elementarmodule von zwei verschiedenen Modulen (10) einen gemeinsamen metallischen Wärmetauscher (2)haben.

## Claims

1. A power electronic module comprising two individual modules (1) each comprising at least one power electronic component (5) having at least one contact face (6) mounted on a metallic face (7) of a substrate (8), control connections (9, 14, 20) for connecting the component (1) to a control module, power connections (11, 13, 20) for transmitting power between components (5) and/or to other individual modules (1) and at least one metallic heat exchanger (2) for evacuating the power dissipated by the power electronic component (5) caused by the Joule effect, said metallic heat exchanger (2) being mounted on the other face (12) of the substrate (8), in which
the two individual modules (1) are face to face, the power electronic component (5) of one individual module (1) facing the power electronic component (5) of the other individual module (1), and separated from each other by at least one spacer (3) comprising control leads (14) for controlling the individual modules (1) and power leads (13) for transmitting power to the individual modules (1) or between individual modules (1).

2. A power electronic module according to claim 1 **characterized in that** it comprises clamping means (4) for fastening the individual modules (1) to the spacer (3) by clamping.

3. A power electronic module according to claim 1 or claim 2 **characterized in that** the substrate (8) is of DBC comprising two faces (9, 11, 7; 12) metallized with copper separated by an electrically insulative ceramic layer (16).

4. A power electronic module according to any of claims 1 to 3 **characterized in that** the metallic heat exchanger (2) comprises a heat-conveying fluid circulation circuit (17).

5. A power electronic module according to claim 4 **characterized in that** the metallic face (12) of the substrate (8) in contact with the heat exchanger (2) constitutes one wall of the circulation circuit (17) of said heat exchanger (2).

6. A power electronic device **characterized in that** it comprises a plurality of modules (10) according to any of claims 1 to 5 stacked one on the other and fastened together by clamping means (4).

7. A power electronic device according to claim 6 **characterized in that** two adjacent individual modules of two different modules (10) have a common metallic heat exchanger (2).
